# EUROPÄISCHE PATENTSCHRIFT

(11) **EP 3 597 016 B1**
(45) Veröffentlichungstag und Bekanntmachung des Hinweises auf die Patenterteilung: **05.05.2021**
(21) Anmeldenummer: 18711545.6
(22) Anmeldetag: 14.03.2018
(51) Int. Cl.: H05H 1/24, H01L 41/00

(54) **VORRICHTUNG ZUR ERZEUGUNG EINES NICHTTHERMISCHEN ATMOSPHÄRENDRUCK-PLASMAS**
DEVICE FOR GENERATING A NON-THERMAL ATMOSPHERIC PRESSURE PLASMA
DISPOSITIF DE GÉNÉRATION D'UN PLASMA NON THERMIQUE À PRESSION ATMOSPHÉRIQUE

(30) Priorität: 14.03.2017 DE 102017105401
(43) Veröffentlichungstag der Anmeldung: 22.01.2020
(73) Patentinhaber: TDK Electronics AG, 81671 München (DE)
(72) Erfinder: PICHLER, Johann, 8614 Breitenau am Hochlantsch (AT); WEILGUNI, Michael, 4232 Hagenberg (AT)
(74) Vertreter: Epping - Hermann - Fischer
(86) Internationale Anmeldenummer: PCT/EP2018/056431
(87) Internationale Veröffentlichungsnummer: WO 2018/167167

(56) Entgegenhaltungen:
- CN-A- 101 259 036
- JP-A- 2003 346 669
- ITOH H ET AL: "Discharge plasmas generated by piezoelectric transformers and their applications; Discharge plasmas generated by piezoelectric transformers", PLASMA SOURCES SCIENCE AND TECHNOLOGY, INSTITUTE OF PHYSICS PUBLISHING, BRISTOL, GB, Bd. 15, Nr. 2, 1. Mai 2006 (2006-05-01), Seiten S51-S61, XP020105199, ISSN: 0963-0252, DOI: 10.1088/0963-0252/15/2/S07
- LINEYKIN S ET AL: "Feedback isolation by piezoelectric transformers: comparison of amplitude to frequency modulation", POWER ELECTRONICS SPECIALISTS CONFERENCE, 2004. PESC 04. 2004 IEEE 35TH ANNUAL, AACHEN, GERMANY 20-25 JUNE 2004, PISCATAWAY, NJ, USA,IEEE, US, Bd. 3, 20. Juni 2004 (2004-06-20), Seiten 1834-1840, XP010739460, DOI: 10.1109/PESC.2004.1355395 ISBN: 978-0-7803-8399-9

## Beschreibung

Die vorliegende Erfindung betrifft eine Vorrichtung zur Erzeugung eines nichtthermischen Atmosphärendruck-Plasmas. Die Vorrichtung weist einen piezoelektrischen Transformator auf. Die Vorrichtung ist ferner dazu ausgestaltet, ein Schallsignal zu erzeugen.

H Itoh et al, "Discharge plasmas generated by piezoelectric transformers and their applications",Plasma sources Sci Technol.15(2006)S51-S61, offenbart ein Beispiel einer Vorrichtung zur Erzeugung eines Atmosphärendruck-Plasmas aufweisend einen piezoelektrischen Transformator.

Durch eine Vorrichtung, die es ermöglicht, sowohl ein nichtthermisches Atmosphärendruck-Plasma als auch ein Schallsignal zu erzeugen, können in vielen Anwendungen Synergien zwischen dem Plasma und dem Schallsignal genutzt werden. Beispielsweise können sowohl ein nichtthermisches Atmosphärendruck-Plasma als auch ein Schallsignal im Ultraschallfrequenzbereich zur Reinigung und zur Desinfektion genutzt werden. Wird nunmehr mittels der Vorrichtung sowohl Plasma als auch Ultraschall erzeugt, können beide zur gleichzeitigen Reinigung und Desinfektion genutzt werden, wodurch ein hoher Wirkungsgrad der Reinigung und Desinfektion erreicht wird.

Es sind auch Anwendungen der Vorrichtung möglich, bei denen lediglich das Schallsignal für den angestrebten Zweck benötigt wird. Beispielsweise kann in einem Plasmalautsprecher durch die Erzeugung eines Plasmas ein Schallsignal generiert werden. Plasmalautsprecher zeichnen sich durch einen linearen Frequenzgang über einen weiten Frequenzbereich aus. Ein linearer Frequenzgang liegt in dem Frequenzbereich vor, in dem die Leistung eines erzeugten Schallsignals bei vorgegebener Eingangsleistung für unterschiedliche Frequenzen des Bereichs nicht wesentlich variiert, z.B. um weniger als 5 dB.

Aufgabe der vorliegenden Erfindung ist es, eine Vorrichtung anzugeben, die es ermöglicht, sowohl ein Schallsignal als auch ein nichtthermisches Atmosphärendruck-Plasma zu erzeugen.

Diese Aufgabe wird durch eine Vorrichtung gemäß dem vorliegenden Anspruch 1 gelöst.

Es wird eine Vorrichtung zur Erzeugung eines nichtthermischen Atmosphärendruck-Plasmas vorgeschlagen, die einen ersten piezoelektrischen Transformator, der dazu ausgestaltet ist, in einem Prozessmedium ein nichtthermisches Atmosphärendruck-Plasma zu zünden, und eine Ansteuerschaltung, die dazu ausgestaltet ist, an den ersten piezoelektrischen Transformator eine Eingangsspannung anzulegen, aufweist, wobei die Ansteuerschaltung dazu ausgestaltet ist, eine Modulation der Eingangsspannung derart vorzunehmen, dass der erste piezoelektrische Transformator infolge der Modulation ein Schallsignal erzeugt.

Die vorliegende Erfindung betrifft somit eine Vorrichtung, bei der mittels eines piezoelektrischen Transformators, an dessen ausgangsseitiger Stirnseite ein Plasma gezündet werden kann, sowohl Plasma als auch ein Schallsignal erzeugbar sind. Wird die an den piezoelektrischen Transformator angelegte Eingangsspannung moduliert, so weist auch die in einem Ausgangsbereich des piezoelektrischen Transformators erzeugte Hochspannung die Modulation auf. Somit schwanken die Leistung der Hochspannung und damit auch die Amplitude eines nichtthermischen Atmosphärendruck-Plasmas, das von dem piezoelektrischen Transformator erzeugt wird, entsprechend der Modulation der Eingangsspannung. Es wird nunmehr durch die Schwankung in der Amplitude des erzeugten Plasmas ein Schallsignal erzeugt. Dabei kann ein den piezoelektrischen Transformator umgebendes Prozessmedium schwingen. Durch die Änderung des Volumens einer erzeugten Plasmaflamme kommt es zu Druckunterschieden im Prozessmedium, die als Schallsignal wahrgenommen werden. Die Druckschwankungen in Folge der Modulation des erzeugten Plasmas können somit zu einer Vibration des Prozessmediums führen, durch die ein Schallsignal erzeugt wird.

Dadurch, dass das Plasma, dessen Amplitude zur Schallerzeugung moduliert wird, mittels eines piezoelektrischen Transformators erzeugt wird, können eine Vielzahl von Vorteilen erzielt werden.

Die Baugröße der Vorrichtung kann sehr gering gestaltet werden, da für die Übertragung des Schallsignals keine Überträgerbauteile erforderlich sind. Ferner kann das System frei von mechanischer Trägheit sein, da bei der Schallerzeugung mittels Plasma keine mechanische Membran erforderlich ist, sondern unmittelbar Schwingungen des Prozessmediums bewirkt werden können. Dementsprechend kann ein Schallsignal in einem sehr großen Frequenzbereich erzeugt werden. Im Gegensatz dazu ist bei mechanischen Systemen zur Schallerzeugung eine erreichbare obere Grenzfrequenz üblicherweise durch die Trägheit des Systems begrenzt. Wird das Schallsignal mittels des piezoelektrischen Transformators erzeugt, so ist die obere Grenzfrequenz von der Geometrie des Transformators beschränkt, sodass eine sehr hohe obere Grenzfrequenz erreicht werden kann. Ferner wird bei einem piezoelektrischen Transformator die obere Grenzfrequenz auch durch das Material des Transformators und dessen piezoelektrische und mechanische Güte bestimmt.

Wird für den piezoelektrischen Transformator eine PZT-Keramik als piezoelektrisches Material verwendet, so liegt die obere Grenzfrequenz für eine Bauteillänge von 30 mm bei 130 kHz. Für einen piezoelektrischen Transformator, dessen piezoelektrisches Material eine bleifreie Keramik ist, kann die obere Grenzfrequenz bei einer Länge des piezoelektrischen Transformators von 50 mm ebenfalls etwa 130 kHz betragen. Durch eine Verringerung der Länge des Transformators könnte die obere Grenzfrequenz weiter erhöht werden.

Auch gegenüber Systemen, bei denen Spulentransformatoren zur Erzeugung von Plasma und Schall verwendet werden, bietet die Vorrichtung, bei der das Plasma mittels eines piezoelektrischen Transformators erzeugt wird, wesentliche Vorteile. Da bei der erfindungsgemäßen Vorrichtung keine Hochspannungstransformatoren erforderlich sind, kann die Vorrichtung mit einer geringen Bauteilgröße gefertigt werden. Dementsprechend kann sie in einfacher Weise in einen Lautsprecher oder ein Lautsprechersystem integriert werden. Ferner ist der Energiebedarf eines piezoelektrischen Transformators gering. Dementsprechend kann die Vorrichtung mit einer Batterie betrieben werden. Daraus ergeben sich Sicherheitsvorteile gegenüber Systemen, bei denen eine Netzspannung zur Erzeugung hoher Leistungen benötigt wird.

Bei der Vorrichtung kann es ausreichend sein, den piezoelektrischen Transformator von dominanten elektromagnetischen Wellen abzuschirmen. Es kann jedoch darauf verzichtet werden, weitere Elemente der Vorrichtung abzuschirmen. Auch dadurch kann eine geringe Baugröße der Vorrichtung ermöglicht werden.

Die geringe Baugröße sowie die geringen Spannungs- und Leistungserfordernisse der Vorrichtung sowie eine Unempfindlichkeit des piezoelektrischen Transformators gegen Beschädigungen führen dazu, dass für die Vorrichtung ein breites Anwendungsfeld denkbar ist. Denkbar ist beispielsweise die Verwendung der Vorrichtung in der Zahnheilkunde. Dabei könnten Zähne und/oder Zahnfleisch mittels Plasma und einem Schallsignal im Ultraschallfrequenzbereich gereinigt und desinfiziert werden. Systeme, bei denen für die Plasmaerzeugung eine Netzspannung erforderlich ist, können für diese Anwendung nicht verwendet werden oder nur unter Beachtung besonderer Vorsichtsmaßnahmen und damit verbundenem Mehraufwand, da aufgrund der Netzspannung Sicherheitsrisiken bestehen. Darüber hinaus sind Systeme, bei denen für die Plasmaerzeugung eine Netzspannung erforderlich ist, aufgrund einer zu großen Bauteilgröße für die Anwendung in der Zahnheilkunde oftmals ungeeignet.

Als Prozessmedium kann das Medium bezeichnet werden, in dem das Plasma gezündet wird. Bei dem Prozessmedium kann es sich beispielsweise um eine Umgebungsluft des piezoelektrischen Transformators handeln. Bei dem Prozessmedium kann es sich ferner um jeden bei der Verwendungstemperatur und dem Verwendungsdruck gasförmig vorliegende Stoff, sämtliche denkbaren bei der Verwendungstemperatur und dem Verwendungsdruck gasförmig vorliegenden Stoffgemische, ein Aerosol, das flüssige und/oder feste in Gas schwebende Teilchen aufweist, eine Flüssigkeit oder biologisches Gewebe handeln. Der Verwendungsdruck und die Verwendungstemperatur geben den Druck bzw. die Temperatur an, bei der die Vorrichtung zur Erzeugung des nichtthermischen Atmosphärendruck-Plasmas üblicherweise eingesetzt wird. Bei dem Verwendungsdruck kann es sich insbesondere um einen atmosphärischen Druck handeln. Der Verwendungsdruck kann zwischen 0,2 bar und 1,5 bar liegen, vorzugsweise zwischen 0,8 bar und 1,2 bar. Bei der Verwendungstemperatur kann es sich insbesondere um eine Raumtemperatur handeln. Die Verwendungstemperatur kann in einem Bereich zwischen -50°C und +155°C, vorzugsweise zwischen 0°C und 45°C, liegen.

Handelt es sich bei dem Prozessmedium um einen gasförmig vorliegenden Stoff, kann es sich beispielsweise um ein Reingas, z.B. reines He, reines Ar, reines N₂, reines O₂, reines CO₂, reines H₂ oder reines Cl₂ handeln. Ferner kann das Prozessmedium H₂O im überkritischen Bereich sein. Das Prozessmedium kann überkritische, d.h. bei Verwendungstemperatur und Verwendungsdruck nicht kondensierbare, Reinstoffe aufweisen.

Das Prozessmedium kann eines oder eine Mischung mehrerer der vorgenannten Reingase oder der folgenden Gase aufweisen: Luft, Schutzgas und Formiergas. Dabei ist das Prozessmedium so gewählt, dass bei Verwendungstemperatur und Verwendungsdruck der Gaszustand erhalten bleibt.

Das Prozessmedium kann ein Flüssigkeitsaerosol in einem Gas oder einem Gasgemisch aufweisen. Dabei kann es sich beispielsweise um Luft über dem Taupunkt, Sattdampf oder ein Benzin/Diesel-Luftgemisch handeln. Das Prozessmdium kann ein Feststoffsaerosol in einem Gas oder einem Gasgemisch aufweisen. Dabei kann es sich beispielsweise um Ruß in Abgas oder Feinstaub in Luft handeln. Für medizinische und technische Anwendungen können bei der Verwendung von Aerosolen als Prozessmedium besonders gute Resultate erzielt werden. Bei dem Aerosol kann es sich insbesondere um Wassertöpfchen in Luft handeln. Ferner kann es sich um Tröpfchen von H₂O₂ oder Formaldehyd handeln. Durch die Behandlung der Wassertröpfchen mit Plasma können OH Radikale erzeugt werden. Ferner können Wassertröpfchen dazu dienen, die entstehenden Reizgase, beispielsweise Ozon oder Stickoxid, zu binden und damit die Umgebungsbelastung mit diesen Gasen zu vermindern, um die Anwendungssicherheit zu erhöhen. Diese Reizgasbindung kann zusätzlich eine Wirkerhöhung durch Reizgas insbesondere zur Sterilisation bewirken, beispielsweise durch in Wassertröpfchen gelöstes Ozon. Die Vorrichtung könnte auch in Abgasströmen zur Partikelabscheidung verwendet werden. Die Vorrichtung könnte auch in Dampfkreisläufen oder Sanitärräumen sowie deren Lüftungskreisläufen verwendet werden, wobei ebenfalls Aerosole das Prozessmedium bilden können.

Die Vorrichtung kann in einer Erzeugereinheit zur Erzeugung von Plasma und Schall angeordnet sein. Bei der Erzeugereinheit kann es sich beispielsweise um einen Lautsprecher, ein medizinisches Gerät, ein Gerät zur Schädlingsabwehr oder ein Rohrsystem handeln. Die Erzeugereinheit kann ein Außengehäuse aufweisen, in dem die Vorrichtung angeordnet ist. Die Vorrichtung kann aber auch selbstständig, d.h. ohne Erzeugereinheit mit Außengehäuse, eingesetzt werden.

Wird Schall durch die Modulation in der Plasmaerzeugung des piezoelektrischen Transformators erzeugt, können die folgenden Störmechanismen auftreten, die zu einem Rauschen führen können: Der piezoelektrische Transformator wird zu Schwingungen angeregt. Diese Schwingungen können sich auf eine Befestigung des Transformators und/oder ein Gehäuse, in dem der Transformator angeordnet ist, übertragen, wodurch ein Schallsignal erzeugt werden kann, dessen Frequenz im Wesentlichen der Anregungsfrequenz entspricht, mit der der piezoelektrische Transformator betrieben wird. Um zu verhindern, dass dadurch ein Rauschen im akustisch wahrnehmbaren Bereich entsteht, wird die Anregungsfrequenz des Transformators vorzugsweise hinreichend groß gewählt. Die Anregungsfrequenz kann beispielsweise größer als 100 kHz, vorzugsweise größer als 130 kHz, betragen. In diesen Fällen führen die durch die Schwingungen des piezoelektrischen Transformators hervorgerufenen Vibrationen nicht zu hörbaren Schallsignalen.

Auch das erzeugte Plasma kann ein Rauschen aufweisen. Dieses Rauschen kann durch ein regelmäßiges Ausbleiben der Plasmazündungen hervorgerufen werden. Dieser Störmechanismus sowie Möglichkeiten zur Reduzierung des Rauschens des Plasmas werden später genauer beschrieben.

Die Modulation kann eine Amplitudenmodulation sein. Dabei kann die Ansteuerschaltung dazu ausgestaltet sein, eine Wechselspannung mit einer Trägerfrequenz als Eingangsspannung an den piezoelektrischen Transformator anzulegen und die Amplitude der angelegten Eingangsspannung mit einer Modulationsfrequenz zu modulieren, wobei die Modulationsfrequenz kleiner als die Trägerfrequenz ist. Beispielsweise kann die Modulationsfrequenz um mindestens einen Faktor 10 kleiner sein als die Trägerfrequenz. Die Modulationsfrequenz entspricht dabei der gewünschten Tonfrequenz des zu erzeugenden Schallsignals. Die Trägerfrequenz kann durch die Geometrie und das Material des piezoelektrischen Transformators festgelegt sein. Durch die Bauteillänge, das heißt den Abstand einer eingangsseitigen Stirnseite von einer ausgangsseitigen Stirnseite des piezoelektrischen Transformators, wird seine Resonanzfrequenz bestimmt. Die Trägerfrequenz sollte in unmittelbarer Nähe zu der Resonanzfrequenz liegen, das heißt die Trägerfrequenz sollte nur um wenige Hertz, beispielsweise um nicht mehr als 50 Hz, von der Resonanzfrequenz abweichen.

Das Schallsignal kann Frequenzen in einem hörbaren Frequenzbereich und/oder in einem Ultraschallfrequenzbereich aufweisen. Das Schallsignal kann beispielsweise Frequenzen in einem Bereich zwischen 0 Hz und 10² kHz aufweisen. Frequenzen zwischen 16 Hz bis 20 kHz werden hier als hörbarer Frequenzbereich angesehen. Der Ultraschallfrequenzbereich kann Frequenzen von 20 kHz bis 1,6 GHz aufweisen. Frequenzen aus dem Ultraschallfrequenzbereich sind für den Menschen nicht hörbar, da diese zu hochfrequent sind.

Die Vorrichtung kann ein Gehäuse aufweisen, in dem der piezoelektrische Transformator angeordnet ist. Das Gehäuse kann ein Resonanzvolumen sein. Das Gehäuse kann dazu ausgestaltet sein, bei einer Plasmaerzeugung entstandenes Ozon zu vernichten. Alternativ oder ergänzend kann das Gehäuse auch dazu ausgestaltet sein, weitere bei der Plasmaerzeugung entstehende Reizgase zu vernichten.

Das Gehäuse kann beispielsweise ein katalytisch aktives Drahtgeflecht aufweisen. Das Drahtgeflecht kann den Transformator umschließen. Alternativ kann das Gehäuse trompetenförmig ausgebildet sein und beispielsweise aus Kupfer oder einem anderen Metall bestehen. Das Gehäuse kann ein Faraday'scher Käfig sein. Das Gehäuse kann mit MnO₂ (Braunstein) beschichtet sein. Die hier genannten Ausführungsformen des Gehäuses ermöglichen es jeweils, dass bei der Plasmaerzeugung erzeugtes Ozon und andere Reizgase durch das Gehäuse vernichtet wird. Dementsprechend kann eine Kontamination mittels potentiell gesundheitsschädlichem Ozon verhindert werden. Bei zahlreichen Anwendungen, beispielsweise bei der Verwendung der Vorrichtung in einem Lautsprecher, stellt das Plasma lediglich ein Nebenprodukt zu der gewünschten Schallerzeugung dar. Das Gehäuse bietet für diese Anwendungen eine effektive Möglichkeit, die Ozonkontamination zu vermeiden.

Die Ausgestaltung des Gehäuses als Drahtgeflecht oder in Trompetenform kann es ermöglichen, das erzeugte Ozon in einer Weise zu vernichten, die ein von dem Transformator erzeugtes Schallsignal nicht beeinträchtigt oder dämpft. Das Schallsignal kann durch Öffnungen in dem Drahtgeflecht oder der Trompetenform ungehindert austreten.

Bei dem Transformator kann es sich um einen Rosentransformator handeln. Der Transformator kann insbesondere einen Eingangsbereich, an den eine Eingangsspannung anlegbar ist, und einen Ausgangsbereich aufweisen, wobei an einer ausgangsseitigen Stirnseite des Ausgangsbereichs, die vom Eingangsbereich weg weist, eine Hochspannung erzeugt wird, wenn an den Eingangsbereich eine Eingangsspannung angelegt wird. Die Eingangsspannung ist dabei eine Niederspannung und kann beispielsweise von einer Batterie stammen. Mittels der an der ausgangsseitigen Stirnseite erzeugten Hochspannung kann Plasma erzeugt werden.

Der Transformator kann einen Ausgangsbereich aufweisen, an dem eine Hochspannung erzeugbar ist, die ausreicht, um ohne eine separate Gegenelektrode in dem Prozessmedium das nichtthermische Atmosphärendruck-Plasma zu zünden. Die erzeugte Ausgangsspannung kann dabei so groß sein, dass diese ausreicht, Atome und Moleküle des Prozessmediums zu ionisieren.

Alternativ kann die Vorrichtung ferner eine Gegenelektrode aufweisen, wobei die Vorrichtung dazu ausgestaltet ist, das Plasma mittels einer zwischen einem Ausgangsbereich des piezoelektrischen Transformators und der Gegenelektrode erzeugten Spannung zu zünden.

Der Verzicht auf eine Gegenelektrode kann eine weiter miniaturisierte Bauform der Vorrichtung ermöglichen. Die Verwendung der Gegenelektrode kann es ermöglichen, einen erzeugten Plasmastrahl in gewünschter Weise zu formen. Ferner kann durch das Zünden des Plasmas gegen eine Gegenelektrode ein akustisches Rauschen, welches durch den Plasmastrahl hervorgerufen werden kann, sehr stark bis gänzlich unterdrückt werden, was insbesondere für die Verwendung der Vorrichtung als Hochtöner im Audiobereich eine erhebliche Qualitätsverbesserung bedingt.

Die Vorrichtung kann dazu vorgesehen und geeignet sein, chemische Reaktionen zu ermöglichen, zu beschleunigen oder zu katalysieren. Die Vorrichtung kann insbesondere zur Vernichtung oder zum Abbau von Schadstoffen, z.B. Stickoxiden, Kohlenmonoxid und/oder Feinstaub, vorgesehen und geeignet sein.

Die Vorrichtung kann dazu vorgesehen und geeignet sein, Oberflächen zu aktivieren oder zu sterilisieren.

Das oben bereits erwähnte Rauschen des Plasmas kann durch folgenden Mechanismus erzeugt werden: Nicht bei jedem Nulldurchgang bzw. jeder Halbwelle der an den Transformator angelegten Eingangsspannung kommt es tatsächlich zu einer Plasmazündung. Wird auf eine Gegenelektrode verzichtet, kommt es bei etwa jedem dritten bis jedem vierten Nulldurchgang zu einem Aussetzer, d.h. zu einem Ausbleiben einer Plasmazündung. Folglich werden die Plasmazündungen in der Frequenz des Ansteuersignals durch die Aussetzer überlagert, die mit einer Frequenz auftreten, die beispielsweise ein Viertel der Ansteuerfrequenz beträgt. Beträgt beispielsweise die Ansteuerfrequenz 50 kHz, können die Aussetzer mit einer Frequenz von etwa 15 kHz auftreten. Dementsprechend können die Aussetzer mit einer Frequenz im hörbaren Bereich auftreten. Durch das Ausbleiben der Plasmazündungen kann somit ein akustisch wahrnehmbares Rauschen erzeugt werden. Wird nunmehr das Plasma gegen eine Gegenelektrode gezündet, tritt das Ausbleiben der Plasmazündungen seltener auf. Damit kann die Frequenz des Rauschens in den Ultraschallbereich verschoben werden. Dieses ist insbesondere bei der Verwendung der Vorrichtung in einem Plasmalautsprecher von wesentlicher Bedeutung.

Alternativ oder ergänzend kann das Rauschen des Plasmas auch dadurch in den Ultraschallbereich verschoben werden, dass der piezoelektrische Transformator mit einer wesentlich höheren Ansteuerfrequenz angesteuert wird. Eine gleiche Häufigkeit des Ausbleibens einer Plasmazündung vorausgesetzt, würde auch in diesem Fall die Frequenz des Rauschens in den Ultraschallbereich wandern. Um ein Rauschen des Plasmas im hörbaren Frequenzspektrum zu vermeiden, kann die Anregungsfrequenz beispielsweise größer als 100 kHz, vorzugsweise größer als 130 kHz, sein. In diesen Fällen führt das regelmäßige Ausbleiben der Plasmazündungen lediglich zu einem Rauschen, dessen Frequenz außerhalb des hörbaren Bereichs liegt.

Es kann sich bei dem Prozessmedium um ein Abgas handeln. Es kann sich bei dem Abgas insbesondere um Abgas eines Verbrennungsmotors handelt.

In einem weiteren Ausführungsbeispiel kann unmittelbar anliegend an eine ausgangsseitige Stirnseite des ersten piezoelektrischen Transformators eine dielektrische Barriere angeordnet sein, wobei die Vorrichtung dazu ausgestaltet ist, eine an der ausgangsseitigen Stirnseite erzeugte Hochspannung kapazitiv in einen Zündungsraum einzukoppeln, in dem sich das Prozessmedium befindet, so dass in dem Zündungsraum ein nichtthermisches Atmosphärendruck-Plasma in dem Prozessmedium gezündet wird. Dementsprechend wird in diesem Ausführungsbeispiel das Plasma nicht unmittelbar an der ausgangsseitigen Stirnseite des Transformators gezündet, sondern in dem Zündungsraum, der räumlich von der Stirnseite durch die dielektrische Barriere getrennt ist.

Bei der dielektrischen Barriere kann es sich beispielsweise um eine Schicht handeln, die Glas, SiO₂ oder Al₂O₃ aufweist.

Die dielektrische Barriere kann durch eine Beschichtung des Transformators gebildet werden. Die Beschichtung kann entweder den piezoelektrischen Transformator vollständig bedecken, wobei die Außenelektroden frei von der Beschichtung bleiben, oder die Beschichtung kann lediglich den Ausgangsbereich des piezoelektrischen Transformators bedecken.

Alternativ kann der Transformator in einer Kavität angeordnet sein, die den Ausgangsbereich des piezoelektrischen Transformators umschließt. Die Kavität kann Seitenwände aufweisen, wobei die Seitenwände der Kavität die dielektrische Barriere ausbilden. Dabei bestehen die Seitenwände aus einem Dielektrikum. Der Transformator kann in die Kavität eingeschoben werden. Die Kavität kann durch einen Aufsatz ausgebildet sein, der dazu ausgestaltet ist, an der Vorrichtung befestigt zu werden.

Das Zünden des Plasmas in einem vom piezoelektrischen Transformator räumlich getrennten Zündungsraum kann für bestimmte Anwendungen vorteilhaft sein. Handelt es sich bei dem Prozessmedium nicht um ein gasförmiges Medium, sondern um eine Flüssigkeit oder biologisches Gewebe, wird das Plasma vorzugsweise in dem vom piezoelektrischen Transformator räumlich getrennten Zündungsraum gezündet, um zu vermeiden, dass der Transformator und das Prozessmedium in unmittelbaren Kontakt miteinander kommen. Eine Flüssigkeit könnte andernfalls den Transformator beschädigen. Biologisches Gewebe könnte wiederum durch unmittelbaren Kontakt mit dem piezoelektrischen Transformator zerstört werden. Wird die Vorrichtung zur Erzeugung eines nichtthermischen Atmosphärendruck-Plasmas beispielsweise in einem medizinischen Gerät, z.B. einem Endoskop, verwendet, ist an der ausgangsseitigen Stirnseite des ersten piezoelektrischen Transformators vorzugsweise eine dielektrische Barriere angeordnet, um zu vermeiden, dass biologisches Gewebe und der Transformator in unmittelbaren Kontakt miteinander kommen. Dadurch kann die Sicherheit bei der Bedienung des medizinischen Geräts erhöht werden.

Wird Gewebe oder eine Flüssigkeit als Prozessmedium verwendet, so könnte das Prozessmedium die Schwingung des Transformators dämpfen. Durch die Trennung des Transformators und des Prozessmediums durch die dielektrische Barriere kann jedoch sichergestellt werden, dass das Prozessmedium die Schwingung des Transformators nicht dämpft.

Auch bei Anwendungen, bei denen das Plasma unter hohem Druck oder bei hohen Temperaturen gezündet werden soll, ist es vorteilhaft, das Plasma in einem vom Transformator räumlich getrennten Zündungsraum zu zünden. Auf diese Weise kann es vermieden werden, den Transformator dem hohen Druck und/oder der hohen Temperatur auszusetzen. Andernfalls könnten der hohe Druck und/oder die hohe Temperatur den Transformator beschädigen und seine Lebensdauer verringern.

Wird die Vorrichtung zur Zündung eines Plasmas in einem aggressiven Medium oder unter hohen Temperaturen oder unter hohem Druck verwendet, ist die Vorrichtung vorzugsweise derart ausgestaltet, dass nur der Teil des piezoelektrischen Transformators, der von der dielektrischen Barriere umschlossen ist, mit dem Prozessmedium in Kontakt kommt. In diesem Fall handelt es sich bei der dielektrischen Barriere vorzugsweise um ein inertes Dielektrikum, beispielsweise um Glas. Der Rest der Vorrichtung kann von dem Prozessmedium abgekapselt sein.

Alternativ kann eine von dem piezoelektrischen Transformator erzeugte Hochspannung über eine entsprechend ausgestaltete Zielapparatur in eine Zündungskammer eingekoppelt werden. Beispielsweise kann die Zielapparatur ein Rohrstück aus Glas aufweisen, an welches der piezoelektrische Transformator herangeführt werden kann. Die Zielapparatur kann dazu ausgestaltet sein, mit der Zündungskammer mechanisch gekoppelt zu werden. Beispielsweise kann die Zielapparatur mit einem weiteren Rohrstück, das beispielsweise Teil einer Klimaanlage oder Teil eines Dampferzeugers ist, verbunden sein, wobei das Plasma auf diese Weise in die Klimaanlage bzw. den Dampferzeuger eingekoppelt wird. Dementsprechend kann über die Zielapparatur ein erzeugtes Plasma zu dem gewünschten Einsatzort geführt werden.

Ferner ist es bei Anwendungen, bei denen das Prozessmedium leitfähig ist, vorteilhaft, den Transformator durch eine dielektrische Barriere von dem Prozessmedium zu trennen. Dabei kann es sich beispielsweise um Konstruktionsmetalle von Klimaanlagen oder Werkzeugen handeln, in denen die Vorrichtung eingebaut ist.

Ferner kann die dielektrische Barriere auch in Anwendungen vorteilhaft sein, in denen das Plasma zur Erzeugung, Beschleunigung oder Katalyse von chemischen Reaktionen genutzt wird. Für derartige Anwendungen kann es jedoch ebenfalls von Vorteil sein, den Transformator ohne dielektrische Barriere mit dem Prozessmedium in Kontakt zu bringen und direkt in diesem ein Plasma zu zünden.

Ferner kann die Vorrichtung einen zweiten piezoelektrischen Transformator aufweisen, wobei die Ansteuerschaltung dazu ausgelegt sein kann, an den zweiten piezoelektrischen Transformator eine Eingangsspannung derart anzulegen, dass das nichtthermische Atmosphärendruck-Plasma durch eine Spannung zwischen den beiden piezoelektrischen Transformatoren erzeugt wird, wobei der erste und der zweite piezoelektrische Transformator um 180° phasenversetzt zueinander angesteuert werden. Dementsprechend kann das Plasma insbesondere zwischen den beiden Transformatoren gezündet werden. Die an die beiden Transformatoren angelegte Eingangsspannung wird dabei jeweils amplitudenmoduliert.

Auch durch die Zündung des Plasmas zwischen den beiden Transformatoren kann in ähnlicher Weise wie bei der Plasmazündung zwischen einem Transformator und einer Gegenelektrode ein Rauschen unterdrückt werden. Wird das Plasma zwischen zwei gegenphasig betriebenen Transformatoren gezündet, so tritt ein Ausbleiben der Plasmazündung mit einer noch geringeren Frequenz und/oder Häufigkeit auf als bei der Zündung gegen eine Gegenelektrode. Dementsprechend wandert die Frequenz des Rauschens noch weiter in den Ultraschallbereich, so dass das Rauschen akustisch nicht wahrnehmbar ist. Auf Grund der Rauschunterdrückung kann die Qualität des erzeugten Schallsignals erheblich verbessert werden.

Die beiden Transformatoren, zwischen denen das Plasma gezündet wird, können identisch zueinander sein. Alternativ können die Transformatoren sich in ihrer Länge und/oder in ihrem Material voneinander unterscheiden.

Ferner kann die Vorrichtung zumindest einen weiteren piezoelektrischen Transformator aufweisen, der eine Länge aufweist, die von der Länge und/oder vom Material des ersten piezoelektrischen Transformators abweicht. Die Ansteuerschaltung kann ferner dazu ausgestaltet sein, eine Modulation einer an den weiteren Transformator angelegten Eingangsspannung derart vorzunehmen, dass der weitere piezoelektrische Transformator in Folge der Modulation ebenfalls ein Schallsignal erzeugt.

Die Transformatoren können mit unterschiedlichen Frequenzen angesteuert werden. Die Transformatoren können parallel zueinander betrieben werden. Als Parallelbetrieb wird hierbei ein Betrieb bezeichnet, bei dem die Transformatoren nebeneinander angeordnet sind und das Plasma nicht zwischen den Transformatoren gezündet wird. Durch die Verwendung mehrere Transformatoren, die sich in ihre Länge und damit ihrer Resonanzfrequenz voneinander unterscheiden, kann die akustische Qualität eines erzeugten Schallsignals verbessert werden.

Bei der Vorrichtung kann es sich um ein Handgerät handeln. Ein Handgerät kann insbesondere ein tragbares Gerät sein, das für einen mobilen Einsatz an verschiedenen Orten geeignet ist.

Die vorliegende Erfindung betrifft ferner einen Lautsprecher, der eine oben beschriebene Vorrichtung aufweist. Hierbei führt insbesondere der lineare Frequenzgang über einen sehr großen Frequenzbereich des von der Vorrichtung erzeugten akustischen Schallsignals zu einer hohen Qualität des Lautsprechers. Ein solcher Plasmalautsprecher kommt theoretisch einem idealen Hochtonschallwandler sehr nahe, da er das Prozessmedium als Membran verwendet, die es ermöglicht, so gut wie massefrei zu arbeiten und die auch keine Partialschwingungen auftreten lässt, die ansonsten zu klanglichen Verfärbungen normaler Membranmaterialien führen würden.

Die vorliegende Erfindung betrifft ferner einen Auspuff, der eine oben beschriebene Vorrichtung aufweist. Die Vorrichtung kann dabei insbesondere zur Vernichtung oder zum Abbau von Schadstoffen, z.B. Stickoxiden, Kohlenmonoxid und/oder Feinstaub, eingesetzt werden. Alternativ kann die Vorrichtung beispielsweise auch zu Analysezwecken eingesetzt werden.

Die vorliegende Erfindung betrifft ferner ein medizinisches Gerät, das die oben beschriebene Vorrichtung aufweist. In dem Gerät können beispielsweise sowohl das Schallsignal, insbesondere im Ultraschallfrequenzbereich, als auch das Plasma zur Desinfektion und Reinigung verwendet werden. Dabei können Synergien durch die Reinigung mittels zweier unterschiedlicher Signale erzielt werden. In medizinischen Geräten spielen insbesondere die in dem nichtthermischen Atmosphärendruck-Plasma enthaltenen bzw. von die von diesem erzeugten Radikale, sowie weitere erzeugte reaktive Spezies, insbesondere O₃ und NOₓ, eine wichtige Rolle für die jeweiligen Anwendungen, z.B. Kariesbehandlung, Wundbehandlung oder Desinfektion von Oberflächen. Das Plasma kann dabei durch die zusätzliche Kombination mit den erzeugten Schallsignalen zur Steigerung von Reinigungs- und Desinfektionswirkung genutzt werden. Bei den medizinischen Geräten kann es sich beispielsweise um Sonden oder Endoskope handeln.

Ferner betrifft die vorliegende Erfindung ein Gerät zu Schädlingsabwehr, das die oben beschriebene Vorrichtung aufweist. Beispielsweise können Ratten, Mäuse, Marder, aber auch Hunde oder Kinder mittels Ultraschall ferngehalten werden. Auch das Plasma kann zu einem synergetischen Effekt bei der Vertreibung der Schädlinge beitragen. Geräte zur Schädlingsvertreibung können beispielsweise in Autos, Gärten, Lagerhallen oder Rohrsystemen, wie beispielsweise Klimaanlagen, eingesetzt werden.

Gemäß einem weiteren Aspekt betrifft die Erfindung ein Analysegerät zur Partikelanalyse aufweisend eine Vorrichtung, die angeordnet und ausgestaltet ist, Partikel für Analysezwecke und/oder zur Reinigung des Abgasstroms und/oder zum Abbau der betreffenden Partikel zu ionisieren.

Gemäß einem weiteren Aspekt betrifft die Erfindung ein Rohrsystem aufweisend eine der oben beschriebenen Vorrichtungen oder einen Lautsprecher, der eine solche Vorrichtung aufweist, oder einen Auspuff, der eine solche Vorrichtung aufweist, oder ein medizinisches Gerät, das eine solche Vorrichtung aufweist, oder ein Gerät zur Schädlingsabwehr, sdas eine solche Vorrichtung aufweist, oder ein Analysegerät zur Partikelanalyse, das eine solche Vorrichtung aufweist.

Im Folgenden wird die vorliegende Erfindung anhand der Figuren näher beschrieben.
Figur 1 zeigt einen piezoelektrischen Transformator in perspektivischer Ansicht.
Figur 2 zeigt eine Vorrichtung zur Erzeugung eines Plasmas und eines Schallsignals in schematischer Darstellung gemäß einem ersten Ausführungsbeispiel.
Figur 3 zeigt die Vorrichtung gemäß einem zweiten Ausführungsbeispiel in schematischer Ansicht.
Figur 4 zeigt die Vorrichtung gemäß einem dritten Ausführungsbeispiel in schematischer Ansicht.
Figur 5 zeigt die Vorrichtung gemäß einem vierten Ausführungsbeispiel, die zwei parallel zueinander angeordnete Transformatoren aufweist.
Figur 6 zeigt die Vorrichtung gemäß einem fünften Ausführungsbeispiel, bei dem die Plasmazündung hinter einer dielektrischen Barriere erfolgt, in einem Querschnitt.
Figur 7 zeigt die Vorrichtung gemäß einer Variation des fünften Ausführungsbeispiels in einem Querschnitt.
Figur 8 zeigt die in Figur 7 gezeigte Vorrichtung in einer perspektivischen Ansicht.
Figur 9 und Figur 10 zeigen die Vorrichtung gemäß einem sechsten Ausführungsbeispiel.
Figur 11 zeigt eine erste Variation des sechsten Ausführungsbeispiels.
Figur 12 zeigt eine zweite Variation des sechsten Ausführungsbeispiels.
Figur 13 und Figur 14 zeigen eine dritte Variation des sechsten Ausführungsbeispiels.

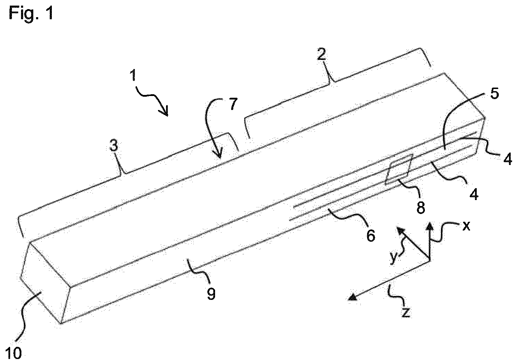

Figur 1 zeigt einen piezoelektrischen Transformator 1 in einer perspektivischen Ansicht. Der piezoelektrische Transformator 1 kann insbesondere in einem Plasmagenerator zur Erzeugung von nichtthermischem Atmosphärendruck-Plasma eingesetzt werden.
Ein piezoelektrischer Transformator 1 ist eine Bauform eines Resonanztransformators, welcher auf Piezoelektrizität basiert und im Gegensatz zu den herkömmlichen magnetischen Transformatoren ein elektromechanisches System darstellt. Der piezoelektrische Transformator 1 ist beispielsweise ein Transformator vom Rosen-Typ.

Der piezoelektrische Transformator 1 weist einen Eingangsbereich 2 und einen Ausgangsbereich 3 auf, wobei der Ausgangsbereich 3 sich in einer Längsrichtung z an den Eingangsbereich 2 anschließt. Im Eingangsbereich 2 weist der piezoelektrische Transformator 1 Elektroden 4 auf, an die eine Wechselspannung angelegt werden kann. Die Elektroden 4 erstrecken sich in der Längsrichtung z des piezoelektrischen Transformators 1. Die Elektroden 4 sind in einer Stapelrichtung x, die senkrecht zu der Längsrichtung z ist, abwechselnd mit einem piezoelektrischen Material 5 gestapelt. Das piezoelektrische Material 5 ist dabei in Stapelrichtung x polarisiert.

Die Elektroden 4 sind im Innern des piezoelektrischen Transformators 1 angeordnet und werden auch als Innenelektroden bezeichnet. Der piezoelektrische Transformator 1 weist eine erste Seitenfläche 6 und eine zweite Seitenfläche 7, die der ersten Seitenfläche 6 gegenüberliegt, auf. Auf der ersten Seitenfläche 6 ist eine erste Außenelektrode 8 angeordnet. Auf der zweiten Seitenfläche 7 ist eine zweite Außenelektrode (nicht gezeigt) angeordnet. Die innenliegenden Elektroden 4 sind in Stapelrichtung x abwechselnd entweder mit der ersten Außenelektrode 8 oder der zweiten Außenelektrode elektrisch kontaktiert.

Der Eingangsbereich 2 kann mit einer geringen Wechselspannung angesteuert werden, die zwischen den Elektroden 4 angelegt wird. Aufgrund des piezoelektrischen Effekts wird die eingangsseitig angelegte Wechselspannung zunächst in eine mechanische Schwingung umgewandelt. Die Frequenz der mechanischen Schwingung ist dabei wesentlich von der Geometrie und dem mechanischen Aufbau des piezoelektrischen Transformators 1 abhängig.

Der Ausgangsbereich 3 weist piezoelektrisches Material 9 auf und ist frei von innenliegenden Elektroden. Das piezoelektrische Material 9 im Ausgangsbereich 3 ist in der Längsrichtung x polarisiert. Bei dem piezoelektrischen Material 9 des Ausgangsbereichs 3 kann es sich um das gleiche Material wie bei dem piezoelektrischen Material 5 des Eingangsbereichs 2 handeln, wobei sich die piezoelektrischen Materialien 5 und 9 in ihrer Polarisationsrichtung unterscheiden können. Im Ausgangsbereich 3 ist das piezoelektrische Material 9 zu einer einzigen monolithischen Schicht geformt, die vollständig in der Längsrichtung z polarisiert ist. Dabei weist das piezoelektrische Material 9 im Ausgangsbereich 3 nur eine einzige Polarisationsrichtung auf.

Wird an die Elektroden 4 im Eingangsbereich 2 eine Wechselspannung angelegt, so bildet sich innerhalb des piezoelektrischen Materials 5, 9 eine mechanische Welle aus, die durch den piezoelektrischen Effekt im Ausgangsbereich 3 eine Ausgangsspannung erzeugt. Der Ausgangsbereich 3 weist eine ausgangsseitige Stirnseite 10 auf. Im Ausgangsbereich 3 wird somit eine elektrische Spannung zwischen der Stirnseite 10 und dem Ende der Elektroden 4 des Eingangsbereichs 2 erzeugt. An der ausgangsseitigen Stirnseite 10 wird dabei eine Hochspannung erzeugt. Dabei entsteht auch zwischen der ausgangseitigen Stirnseite und einer Umgebung des piezoelektrischen Transformators eine hohe Potentialdifferenz, die ausreicht, um ein starkes elektrisches Feld zu erzeugen, dass ein Prozessmedium ionisiert.

Auf diese Weise erzeugt der piezoelektrische Transformator 1 hohe elektrische Felder, die in der Lage sind, Gase oder Flüssigkeiten durch elektrische Anregung zu ionisieren. Dabei werden Atome oder Moleküle des jeweiligen Gases bzw. der jeweiligen Flüssigkeit ionisiert und bilden ein Plasma. Es kommt immer dann zu einer Ionisation, wenn die elektrische Feldstärke an der Oberfläche des piezoelektrischen Transformators 1 die Zündfeldstärke des Plasmas überschreitet. Als Zündfeldstärke eines Plasmas wird dabei die Feldstärke bezeichnet, die zur Ionisation der Atome oder Moleküle erforderlich ist.

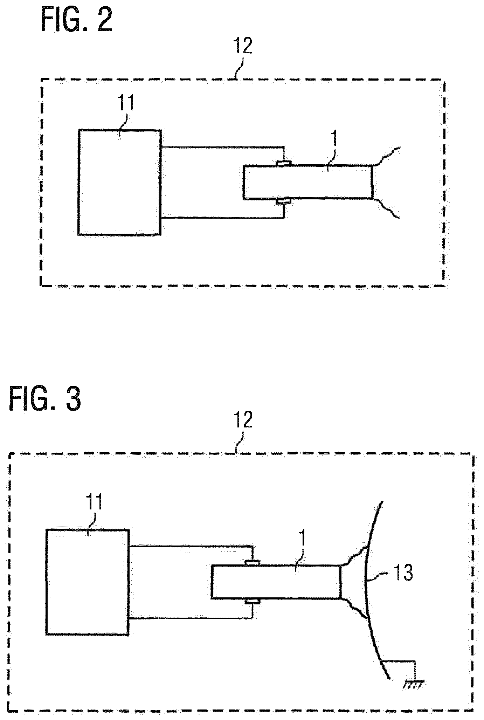

Der in Figur 1 gezeigte piezoelektrische Transformator kann neben der Erzeugung eines nichtthermischen Atmosphärendruck-Plasmas gleichzeitig zur Erzeugung eines Schallsignals verwendet werden. Figur 2 zeigt eine Vorrichtung zur Erzeugung eines Plasmas und eines Schallsignals. Die Vorrichtung weist neben dem piezoelektrischen Transformator 1 ferner eine Ansteuerschaltung 11 auf, die dazu ausgelegt ist, eine Eingangsspannung an den Transformator 1 anzulegen. Bei der Eingangsspannung handelt es sich um die oben beschriebene Wechselspannung, die an die Elektroden 4 des Eingangsbereichs 2 angelegt wird. Die Frequenz der Eingangsspannung wird im Folgenden auch als Trägerfrequenz bezeichnet. Die Frequenz der Eingangsspannung ist gleich oder zumindest nahe der Resonanzfrequenz des piezoelektrischen Transformators 1, um diesen bei der ersten harmonischen Oberwelle zu betreiben.

Die Ansteuerschaltung 11 ist nunmehr dazu ausgestaltet, eine Amplitudenmodulation der an den piezoelektrischen Transformator 1 angelegten Leistung vorzunehmen. Dabei wird eine Amplitude der an den piezoelektrischen Transformator 1 angelegten Eingangsspannung mit einer Modulationsfrequenz moduliert. Die Modulationsfrequenz ist kleiner als die Trägerfrequenz. Entsprechend der Modulation der Amplitude der Eingangsspannung ist auch die an dem Ausgangsbereich 3 des piezoelektrischen Transformators 1 erzeugte Hochspannung moduliert. Die Leistung eines mit dem piezoelektrischen Transformator 1 erzeugten Plasmas schwankt mit der Modulationsfrequenz. Durch die Schwankung in der Leistung des erzeugten Plasmas wird ein Schallsignal erzeugt, dessen Frequenz mit der Modulationsfrequenz übereinstimmt.

Das erzeugte Schallsignal hat einen linearen Frequenzgang in einem Frequenzbereich von 0 Hz bis 10² KHz. Als linearer Frequenzgang wird hierbei ein Verhalten bezeichnet, bei dem die Amplitude des erzeugten Schallsignals unabhängig von der Frequenz des Signals in dem angegebenen Frequenzbereich ist oder zumindest um weniger als 5 dB innerhalb des angegebenen Frequenzbereichs abweicht, wobei von einer gleichbleibenden Eingangsleistung ausgegangen wird.

Die Vorrichtung weist ferner ein Gehäuse 12 auf. Das Gehäuse 12 umgibt den piezoelektrischen Transformator 1. Bei dem in Figur 2 gezeigten Ausführungsbeispiel ist auch die Ansteuerschaltung 11 in dem Gehäuse 12 angeordnet. Alternativ kann die Ansteuerschaltung 11 außerhalb des Gehäuses 12 angeordnet sein.
Bei dem Gehäuse 12 kann es sich um ein katalytisch aktives Drahtgeflecht handeln. Das Gehäuse 12 ist derart ausgestaltet, dass ein von dem Transformator 1 erzeugtes Schallsignal aus dem Gehäuse 12 austreten kann. Das Gehäuse 12 ist dazu ausgestaltet, ein von dem piezoelektrischen Transformator 1 erzeugtes Plasma zu absorbieren. Insbesondere soll das Gehäuse Ozon (O₃), welches bei der Plasmaerzeugung entsteht, absorbieren. Das Gehäuse 12 ist bevorzugt als geerdetes und eventuell katalytisch aktives Drahtgeflecht ausgeführt.

Alternativ kann der piezoelektrische Transformator 1 nur teilweise in einem Gehäuse 12 angeordnet sein. In einer weiteren Ausführungsform ist kein Gehäuse 12 vorgesehen, dass den piezoelektrischen Transformator umgibt.

Alternativ oder ergänzend zu dem Gehäuse 12 kann die Vorrichtung ein Außengehäuse aufweisen, in dem sämtliche weiteren Elemente der Vorrichtung angeordnet sind.
Bei dem in Figur 2 gezeigten Ausführungsbeispiel ist die an dem piezoelektrischen Transformator 1 angelegte Eingangsspannung stark genug, um im Ausgangsbereich 3 des Transformators 1 eine Wechselspannung zu erzeugen, die ein Plasma ohne eine separate Gegenelektrode zündet.

Figur 3 zeigt eine Vorrichtung gemäß einem zweiten Ausführungsbeispiel, bei der eine Gegenelektrode 13 vorgesehen ist. Auch bei dem zweiten Ausführungsbeispiel ist die Ansteuerschaltung 11 dazu ausgestaltet, eine Amplitudenmodulation einer an dem piezoelektrischen Transformator 1 angelegten Eingangsspannung vorzunehmen, die zur Erzeugung des Schallsignals führt.

Die Gegenelektrode 13 ist vor der ausgangsseitigen Stirnseite 10 des piezoelektrischen Transformators 1 angeordnet. Die Gegenelektrode 13 ist mit einem definierten Potential, insbesondere dem Erdpotential, verbunden. Eine Spannung zwischen der ausgangsseitigen Stirnseite 10 des piezoelektrischen Transformators 1 und der Gegenelektrode 13 sorgt für die Plasmazündung. Die Gegenelektrode 13 kann entweder, wie in Figur 3 gezeigt, separat in der Nähe des Ausgangsbereichs 3 des piezoelektrischen Transformators 1 angeordnet sein oder auch dem Gehäuse 12 der Vorrichtung entsprechen. Ferner kann optional ein zusätzliches Außengehäuse vorgesehen sein.

Durch das Zünden eines Plasmas gegen eine Gegenelektrode 13 kann ein akustisches Rauschen, welches durch das Plasma hervorgerufen wird, sehr stark bis gänzlich unterdrückt werden, was insbesondere für die Anwendung als Hochtöner im Audiobereich eine entsprechende Qualitätsverbesserung bedingt.

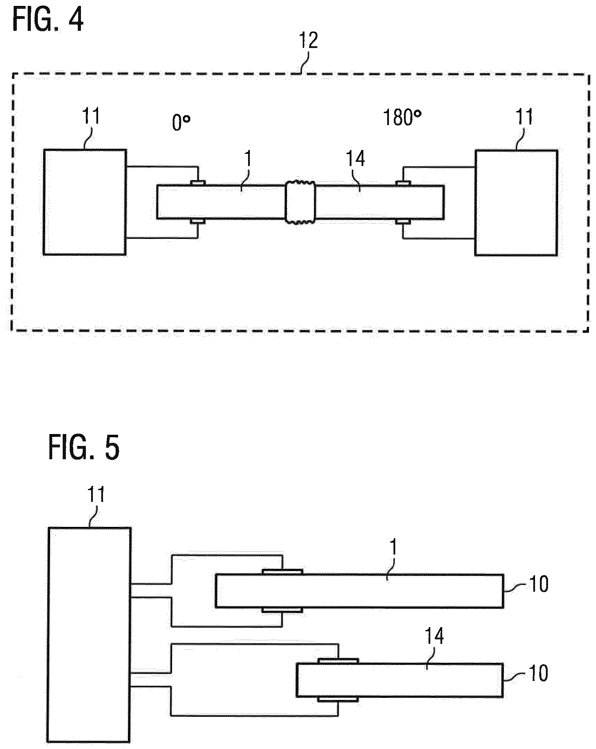

Figur 4 zeigt ein drittes Ausführungsbeispiel der Vorrichtung zur Erzeugung eines nichtthermischen Atmosphärendruck-Plasmas und eines Schallsignals. Die Vorrichtung weist zwei piezoelektrische Transformatoren 1, 14 auf. Die Transformatoren 1, 14 werden von der Ansteuerschaltung 11 phasenversetzt um 180° betrieben. Das Plasma wird zwischen den beiden Transformatoren 1, 14 gezündet. Die Ansteuerschaltung 11 ist wiederum dazu ausgestaltet, eine Amplitudenmodulation der an die beiden piezoelektrischen Transformatoren 1, 14 angelegten Eingangsspannungen vorzunehmen.

Die Ansteuerschaltung 11 kann auf zwei separaten Platinen ausgebildet sein, wobei jeweils eine Platine mit je einem der Transformatoren 1, 14 verbunden ist, wie in der schematischen Darstellung von Figur 4 angedeutet. Alternativ kann die Ansteuerschaltung 11 auf einer einzigen Platine ausgebildet sein, die mit beiden Transformatoren 1, 14 verbunden ist.

Das Zünden des Plasmas zwischen den beiden phasenversetzt betriebenen piezoelektrischen Transformatoren 1, 14 führt ebenfalls zu einer sehr starken oder kompletten Unterdrückung eines weißen, akustischen Rauschens, welches durch die Plasmen hervorgerufen wird.
Ferner könnte die Vorrichtung mehrere nebeneinander angeordnete piezoelektrische Transformatoren 1 aufweisen, die jeweils ein Plasma und ein Schallsignal erzeugen, um beispielsweise die akustische Leistung zu steigern. Die piezoelektrischen Transformatoren 1 könnten sich in ihrer Geometrie und somit in ihrer jeweiligen Resonanzfrequenz voneinander unterscheiden. In diesem Fall ist die Ansteuerschaltung 11 dazu ausgestaltet, die piezoelektrischen Transformatoren mit unterschiedlichen Trägerfrequenzen anzusteuern.

Figur 5 zeigt die Vorrichtung gemäß einem vierten Ausführungsbeispiel. Die Vorrichtung weist ebenfalls zwei piezoelektrische Transformatoren 1, 14 auf. Die beiden piezoelektrischen Transformatoren 1, 14 sind parallel zueinander angeordnet. Dementsprechend weisen die ausgangsseitigen Stirnseiten 10 der beiden piezoelektrischen Transformatoren 1, 14 in die gleiche Richtung. Der beiden piezoelektrischen Transformatoren 1, 14 unterscheiden sich in ihrer Länge. Dementsprechend unterscheiden sich die beiden piezoelektrischen Transformatoren 1, 14 auch in ihrer jeweiligen Resonanzfrequenz.

Die beiden piezoelektrischen Transformatoren 1, 14 sind mit der Ansteuerschaltung 11 verbunden. Die Ansteuerschaltung 11 ist dazu ausgestaltet, an jeden der beiden Transformatoren 1, 14 eine Wechselspannung als Eingangsspannung anzulegen, wobei die Frequenz der Wechselspannung jeweils der Resonanzfrequenz des jeweiligen Transformators 1, 14 entspricht. Die Ansteuerschaltung 11 ist ferner dazu ausgelegt, jeweils eine Modulation der Amplitude der Eingangsspannung vorzunehmen, wobei von jedem der beiden Transformatoren 1, 14 infolge der Modulation ein Schallsignal erzeugt wird.
Das Schallsignal wird somit durch mehrere piezoelektrische Transformatoren 1, 14 erzeugt, die sich in ihrer Resonanzfrequenz und somit in der Frequenz der Eingangsspannung, die von der Ansteuerschaltung 11 an die Transformatoren 1, 14 angelegt wird, unterscheiden. Die Qualität eines erzeugten Schallsignals kann dadurch gegenüber einem Signal, das nur von einem einzigen Transformator 1 erzeugt wird, verbessert werden.

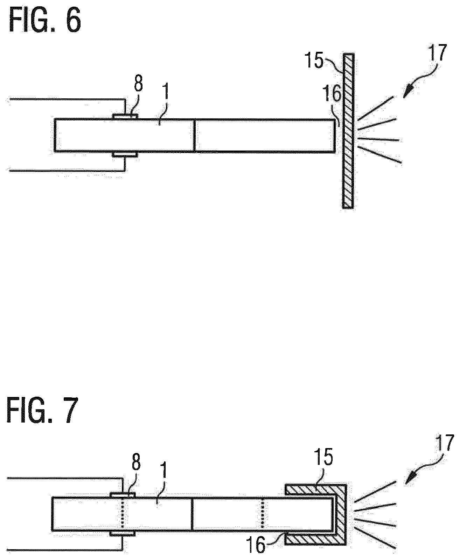

Figur 6 zeigt die Vorrichtung gemäß einem fünften Ausführungsbeispiel. Die Vorrichtung weist einen piezoelektrischen Transformator 1 und eine dielektrische Barriere 15 auf. Die dielektrische Barriere 15 ist unmittelbar vor der ausgangsseitigen Stirnseite 10 des piezoelektrischen Transformators 1 angeordnet. Zwischen dem piezoelektrischen Transformator 1 und der dielektrischen Barriere 15 ist ein Spalt 16 angeordnet.

Die Plasmazündung erfolgt in einem Zündungsraum 17, der von dem piezoelektrischen Transformator 1 durch die dielektrische Barriere 15 getrennt ist. Das Prozessmedium befindet sich in dem Zündungsraum 17. Dementsprechend kommt der piezoelektrische Transformator 1 mit dem Prozessmedium nicht in unmittelbaren Kontakt.

Insbesondere bei Anwendungen, bei denen im Zündungsraum 17 ein hoher Druck und/oder hohe Temperaturen und/oder aggressive oder korrodierende Prozessmedien verwendet werden, ist die Plasmaerzeugung in dem Zündungsraum 17, der von dem piezoelektrischen Transformator 1 durch die dielektrische Barriere 15 getrennt ist, vorteilhaft. In diesem Fall kann vermieden werden, dass der piezoelektrische Transformator 1 durch den hohen Druck, die hohe Temperatur oder das Prozessmedium beschädigt wird. Auch bei Anwendungen, bei denen es sich bei dem Prozessmedium um Flüssigkeiten oder biologisches Gewebe handelt, ist es vorteilhaft, das Plasma in einem Zündungsraum 17 zu erzeugen, der von dem piezoelektrischen Transformator 1 durch die dielektrische Barriere 15 getrennt ist. Bei einer solchen Anwendung kann es sich beispielsweise um ein Endoskop handeln, das einen piezoelektrischen Transformator 1 zur Erzeugung von nichtthermischem Atmosphärendruck-Plasma aufweist.

Ein weiterer Vorteil der Plasmazündung in einem Zündungsraum 17, der von dem piezoelektrischen Transformator 1 durch die dielektrische Barriere 15 getrennt ist, besteht darin, dass in diesem Fall das Prozessmedium die Schwingungen des piezoelektrischen Transformators 1 nicht dämpft. Dieses ist insbesondere bei flüssigen oder festen Prozessmedien von großer Bedeutung.

Auch um Plasmazündungen gegen leitfähige Materialien zu ermöglichen, ohne dabei den piezoelektrischen Transformator 1 zu beschädigen, kann die Plasmazündung hinter einer dielektrischen Barriere 15 vorteilhaft sein.
Bei der dielektrischen Barriere 15 kann es sich um eine dünne Wand handeln, die aus einem beliebigen Dielektrikum, beispielsweise aus Glas, SiO₂ oder Al₂O₃, besteht. Die dielektrische Barriere 15 ist dazu ausgestaltet, eine an der ausgangsseitigen Stirnseite 10 des piezoelektrischen Transformator 1 erzeugte Leistung kapazitiv in den Zündungsraum 17 einzukoppeln und dadurch im Zündungsraum 17 eine Plasmazündung auszulösen.

In einem alternativen Ausführungsbeispiel kann die dielektrische Barriere 15 durch eine Beschichtung des Transformators 1 gebildet werden. In diesem Fall kann die Beschichtung aus einem dielektrischen Material, beispielsweise aus Glas, SiO₂ oder Al₂O₃, bestehen.

Die dielektrische Barriere 15 kann durch einen Aufsatz gebildet sein, der auf dem piezoelektrischen Transformator 1 angeordnet wird. Der Aufsatz kann dazu ausgestaltet sein, ein Prozessmedium der ausgangsseitigen Stirnseite 10 des piezoelektrischen Transformators 1 zuzuführen. Der Aufsatz kann ein Düsenaufsatz sein.

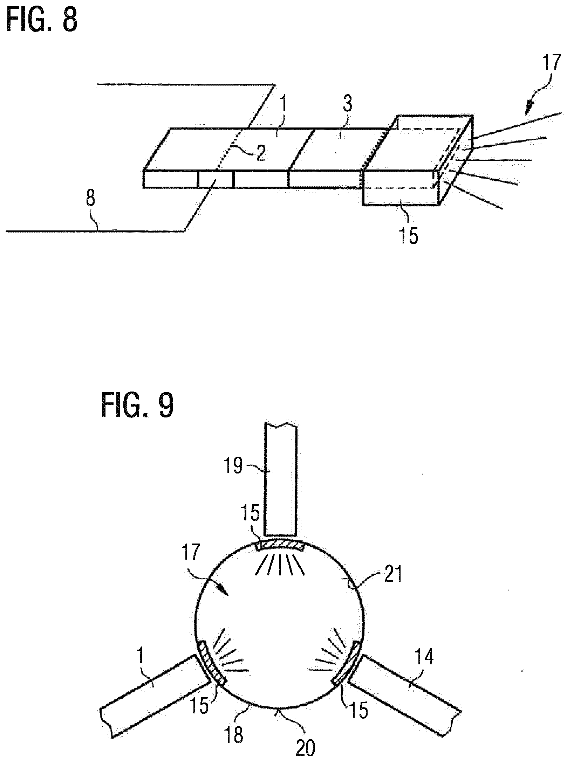

Figur 7 zeigt die Vorrichtung gemäß einer Variation des fünften Ausführungsbeispiels in einem Querschnitt. Figur 8 zeigt diese Vorrichtung in einer perspektivischen Ansicht.

Die dielektrische Barriere 15 ist nicht durch eine flächige Wand gebildet, sondern bildet eine Kavität aus, die die Seitenwände des piezoelektrischen Transformators 1 im Ausgangsbereich 3 teilweise überragt. Der piezoelektrische Transformator 1 kann in die von der dielektrischen Barriere 15 gebildete Kavität eingeschoben werden. Die Kavität kann beispielsweise den piezoelektrischen Transformator 1 auf einem Viertel seiner Länge bedecken. Auch in diesem Fall verbleibt ein Spalt 16 zwischen dem piezoelektrischen Transformator 1 und der dielektrischen Barriere 15. Das Plasma wird in einem Zündungsraum 17 gezündet, der von dem piezoelektrischen Transformator 1 durch die dielektrische Barriere 15 getrennt ist.

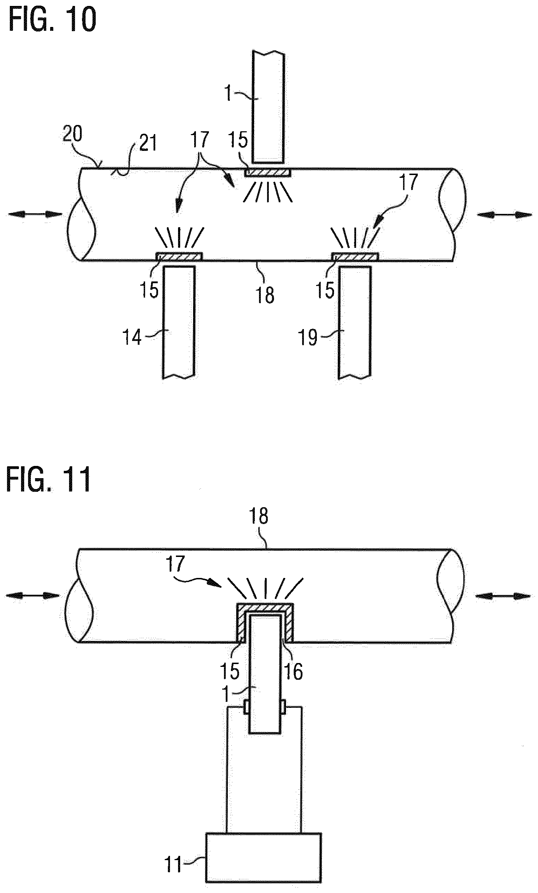

Figur 9 und Figur 10 zeigen die Vorrichtung gemäß einem sechsten Ausführungsbeispiel.
Der Zündungsraum 17 wird hierbei durch ein Rohr 18 gebildet. Das Rohr 18 weist eine Wand auf, die beispielsweise aus Stahl besteht. Das Prozessmedium kann durch das Rohr 18 in eine beliebige Richtung fließen oder sich statisch in dem Rohr 18 befinden.
Die Vorrichtung weist mehrere, beispielsweise drei, piezoelektrische Transformatoren 1, 14, 19 auf, die von dem Zündungsraum 17 jeweils durch eine flächige dielektrische Barriere 15 getrennt sind. Die Transformatoren 1, 14, 19 sind entlang des Rohres 18 angeordnet. Strömt das Prozessmedium entlang des Rohres 18, passiert es dabei nacheinander die drei piezoelektrischen Transformatoren 1, 14, 19.
Die Transformatoren 1, 14, 19 sind auf einer Außenseite 20 des Rohres 18 angeordnet. Die dielektrischen Barrieren 15 sind jeweils auf einer Innenseite 21 des Rohres 18 angeordnet. Dabei sind die dielektrischen Barrieren 15 jeweils unmittelbar vor einem piezoelektrischen Transformator 1, 14, 19 angeordnet und von diesem nur durch die Wand getrennt.

Jeder der Transformatoren 1, 14, 19 kann an seiner ausgangsseitigen Stirnseite 10 eine Hochspannung erzeugen, die über die dielektrische Barriere 15 in das Innere des Rohres 18, d.h. in den Zündungsraum, eingekoppelt wird und dort eine Plasmazündung auslöst. Die Ansteuerschaltung, die mit jedem der piezoelektrischen Transformatoren 1, 14, 19 verbunden ist, ist dazu ausgestaltet, jeden der piezoelektrischen Transformatoren 1, 14, 19 mit einer modulierten Eingangsspannung anzusteuern, so dass ein Schallsignal im Zündungsraum 17 erzeugt wird.

Figur 11 zeigt eine Variation des sechsten Ausführungsbeispiels. Bei dem in Figur 11 gezeigten Ausführungsbeispiel ist die dielektrische Barriere 15 als Kavität ausgebildet, wie beispielsweise auch in den Figuren 7 und 8 gezeigt. Die Wand des Rohres 18, das den Zündungsraum bildet, weist eine Ausnehmung 22 auf, in die die dielektrische Barriere 15 eingebracht ist. Der piezoelektrische Transformator 1 ist wiederum in der Kavität angeordnet.

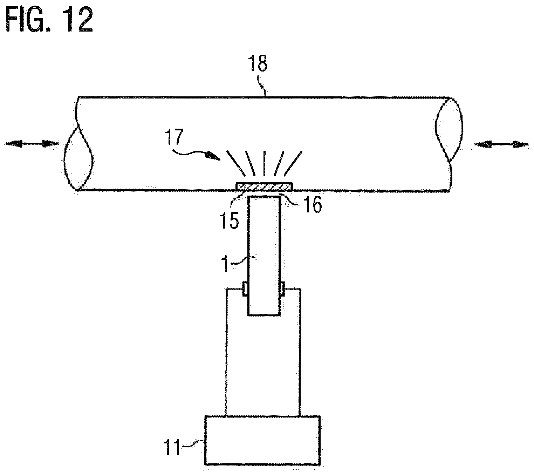

Figur 12 zeigt eine zweite Variation dieses Ausführungsbeispiels. Die in Figur 12 gezeigte Variante unterscheidet sich von dem in Figur 10 gezeigten Ausführungsbeispiel dadurch, dass in dem Rohr 18 nur eine dielektrische Barriere 15 an der Innenseite 21 des Rohres 18 und ein piezoelektrischer Transformator 1 an der Außenseite 22 des Rohres 18 angeordnet ist. Die Anzahl der Transformatoren 1 und dielektrischen Barrieren 15 kann beliebig groß sein.

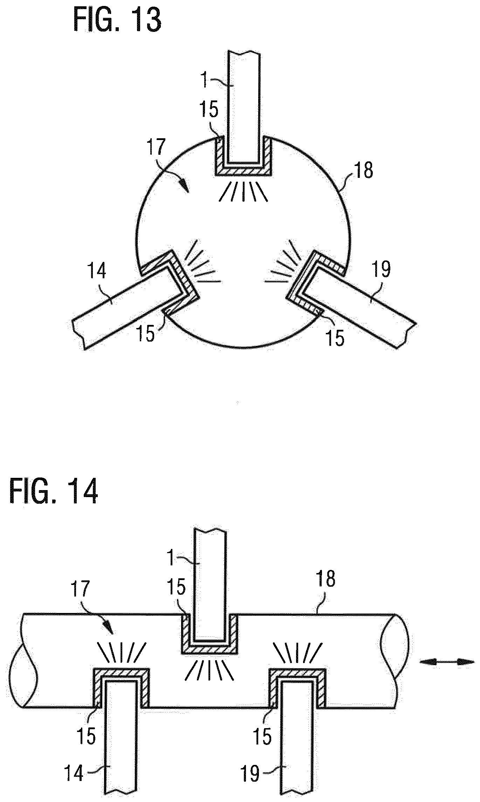

Die Figuren 13 und 14 zeigen eine dritte Variante des sechsten Ausführungsbeispiels, bei der mehrere piezoelektrische Transformatoren 1, 14, 19 vorgesehen sind. Die Wand des Rohres 18 weist mehrere Ausnehmungen 22 auf, in denen jeweils dielektrische Barrieren 15 angeordnet sind, die eine Kavität formen. In jeder dieser Kavitäten ist ein piezoelektrischer Transformator 1, 14, 19 angeordnet, der eine Plasmazündung im Inneren des Rohres 18 erzeugen kann.

Bei jedem der hier gezeigten Ausführungsbeispiele, bei denen eine Plasmazündung in einem Zündungsraum 17 erfolgt, der von dem piezoelektrischen Transformator 1 durch die dielektrische Barriere 15 getrennt ist, ist eine Ansteuerschaltung 11 mit dem piezoelektrischen Transformator 1 verbunden, die dazu ausgestaltet ist, eine Eingangsspannung an den Transformator 1 anzulegen und eine Modulation dieser Eingangsspannung vorzunehmen. Aufgrund der Modulation wird ein Schallsignal erzeugt. Das Schallsignal wird dementsprechend in diesen Ausführungsbeispielen stets im Zündungsraum 17 erzeugt.

### Bezugszeichenliste

- 1: piezoelektrischer Transformator
- 2: Eingangsbereich
- 3: Ausgangsbereich
- 4: Elektrode
- 5: piezoelektrisches Material
- 6: erste Seitenfläche
- 7: zweite Seitenfläche
- 8: erste Außenelektrode
- 9: piezoelektrisches Material
- 10: ausgangsseitige Stirnseite
- 11: Ansteuerschaltung
- 12: Gehäuse
- 13: Gegenelektrode
- 14: piezoelektrischer Transformator
- 15: dielektrische Barriere
- 16: Spalt
- 17: Zündungsraum
- 18: Rohr
- 19: piezoelektrischer Transformator
- 20: Außenseite
- 21: Innenseite
- 22: Ausnehmung

- x: Stapelrichtung
- z: Längsrichtung

## Patentansprüche

1. Vorrichtung zur Erzeugung eines nichtthermischen Atmosphärendruck-Plasmas aufweisend
einen ersten piezoelektrischen Transformator (1), der dazu ausgestaltet ist, in einem Prozessmedium ein nichtthermisches Atmosphärendruck-Plasma zu zünden, und eine Ansteuerschaltung (11), die dazu ausgestaltet ist, an den ersten piezoelektrischen Transformator (1) eine Eingangsspannung anzulegen,
wobei die Ansteuerschaltung (11) dazu ausgestaltet ist, eine Modulation der Eingangsspannung derart vorzunehmen, dass der erste piezoelektrische Transformator (1) in Folge der Modulation ein Schallsignal erzeugt.

2. Vorrichtung gemäß dem vorherigen Anspruch,
wobei die Modulation eine Amplitudenmodulation ist.

3. Vorrichtung gemäß einem der vorherigen Ansprüche,
wobei die Ansteuerschaltung (11) dazu ausgestaltet ist, einen Wechselspannung mit einer Trägerfrequenz als Eingangsspannung an den ersten piezoelektrischen Transformator (1) anzulegen und die Amplitude der angelegten Eingangsspannung mit einer Modulationsfrequenz zu modulieren, wobei die Modulationsfrequenz kleiner ist als die Trägerfrequenz.

4. Vorrichtung gemäß einem der vorherigen Ansprüche,
wobei das Schallsignal Frequenzen in einem hörbaren Frequenzbereich und/oder in einem Ultraschallfrequenzbereich aufweist.

5. Vorrichtung gemäß einem der vorherigen Ansprüche,
wobei die Vorrichtung ein Gehäuse (12) aufweist, in dem der erste piezoelektrische Transformator (1) angeordnet ist.

6. Vorrichtung gemäß dem vorherigen Anspruch,
wobei das Gehäuse (12) ein Resonanzvolumen ist.

7. Vorrichtung gemäß dem vorherigen Anspruch,
wobei das Gehäuse (12) ein katalytisch aktives Drahtgeflecht aufweist.

8. Vorrichtung gemäß einem der Ansprüche 5 bis 7,
wobei das Gehäuse (12) trompetenförmig ist.

9. Vorrichtung gemäß einem der Ansprüche 5 bis 8,
wobei das Gehäuse (12) dazu ausgestaltet ist, bei einer Plasmazündung entstandenes Ozon zu vernichten.

10. Vorrichtung gemäß einem der vorherigen Ansprüche,
wobei es sich bei dem piezoelektrischen Transformator (1) um einen Rosen-Transformator handelt.

11. Vorrichtung gemäß einem der vorherigen Ansprüche,
wobei der erste piezoelektrische Transformator (1) einen Ausgangsbereich (3) aufweist, an dem eine Hochspannung erzeugbar ist, die ausreicht, um ohne eine separate Gegenelektrode in dem Prozessmedium das nichtthermische Atmosphärendruck-Plasma zu zünden.

12. Vorrichtung gemäß einem der Ansprüche 1 bis 10,
wobei die Vorrichtung ferner eine Gegenelektrode (13) aufweist, und wobei die Vorrichtung dazu ausgestaltet ist, das Plasma mittels einer zwischen einem Ausgangsbereich (3) des ersten piezoelektrischen Transformators (1) und der Gegenelektrode (13) erzeugten Spannung zu zünden.

13. Vorrichtung gemäß einem der vorherigen Ansprüche,
zur Ermöglichung, Beschleunigung oder Katalyse von chemischen Reaktionen.

14. Vorrichtung gemäß dem vorherigen Anspruch,
zur Vernichtung oder zum Abbau von Schadstoffen, z.B. Stickoxiden, Kohlenmonoxid und/oder Feinstaub.

15. Vorrichtung gemäß einem der vorherigen Ansprüche, die dazu vorgesehen ist, Oberflächen zu aktivieren oder zu sterilisieren.

16. Vorrichtung gemäß einem der vorherigen Ansprüche,
wobei es sich bei dem Prozessmedium um ein gasförmiges Medium, einen bei einer Verwendungstemperatur und einem Verwendungsdruck gasförmig vorliegenden Stoff, ein bei der Verwendungstemperatur und dem Verwendungsdruck gasförmig vorliegendes Stoffgemische, ein Aerosol, das flüssige und/oder feste in Gas schwebende Teilchen, eine Flüssigkeit oder biologisches Gewebe handelt.

17. Vorrichtung gemäß einem der vorherigen Ansprüche,
wobei es sich bei dem Prozessmedium um ein Abgas handelt.

18. Vorrichtung gemäß dem vorherigen Anspruch,
wobei es sich bei dem Abgas um Abgas eines Verbrennungsmotors handelt.

19. Vorrichtung gemäß einem der vorherigen Ansprüche,
wobei vor einer ausgangsseitige Stirnseite (10) des ersten piezoelektrischen Transformators (1) eine dielektrische Barriere (1) angeordnet ist und wobei die Vorrichtung dazu ausgestaltet ist, eine an der ausgangsseitigen Stirnseite (10) erzeugte Hochspannung kapazitiv in einen Zündungsraum (17) einzukoppeln, in dem sich das Prozessmedium befindet, so dass in dem Zündungsraum (17) ein nichtthermisches Atmosphärendruck-Plasma in dem Prozessmedium gezündet wird.

20. Vorrichtung gemäß einem der vorherigen Ansprüche, die einen zweiten piezoelektrischen Transformator (14) aufweist, der gegenüberliegend zu dem ersten piezoelektrischen Transformator (1) angeordnet ist, wobei die Ansteuerschaltung (11) dazu ausgelegt ist, an den zweiten piezoelektrischen Transformator (14) eine Eingangsspannung derart anzulegen, dass das nichtthermisches Atmosphärendruck-Plasma durch eine Spannung zwischen den beiden piezoelektrischen Transformatoren (1, 14) erzeugt wird, wobei die beiden piezoelektrischen Transformatoren (1, 14) um 180° phasenversetzt zueinander angesteuert werden.

21. Vorrichtung gemäß einem der vorherigen Ansprüche,
wobei die Vorrichtung zumindest einen weiteren piezoelektrischen Transformator (14) aufweist, der parallel zu dem ersten piezoelektrischen Transformator (1) angeordnet ist und der eine andere Länge aufweist als der erste piezoelektrische Transformator (1), wobei die Ansteuerschaltung (11) dazu ausgestaltet ist, eine Modulation einer an den weiteren Transformator (14) angelegten Eingangsspannung derart vorzunehmen, dass der weitere piezoelektrische Transformator (14) in Folge der Modulation ein Schallsignal erzeugt.

22. Vorrichtung gemäß einem der vorherigen Ansprüche,
wobei es sich bei der Vorrichtung um ein Handgerät handelt.

23. Vorrichtung gemäß einem der vorherigen Ansprüche,
wobei eine Amplitude des nichtthermischen Atmosphärendruck-Plasmas, das von dem ersten piezoelektrischen Transformator (1) erzeugt wird, entsprechend der Modulation der Eingangsspannung schwankt.

24. Vorrichtung gemäß einem der vorherigen Ansprüche,
wobei eine Leistung des mit dem ersten piezoelektrischen Transformator (1) erzeugten nichtthermischen Atmosphärendruck-Plasmas mit einer Modulationsfrequenz der Modulation schwankt.

25. Vorrichtung gemäß dem der vorherigen Anspruch,
wobei durch die Schwankung in der Leistung des erzeugten nichtthermischen Atmosphärendruck-Plasmas das Schallsignal erzeugt wird, dessen Frequenz mit der Modulationsfrequenz übereinstimmt.

26. Vorrichtung gemäß einem der vorherigen Ansprüche,
wobei die Vorrichtung zur Verwendung in der Zahnheilkunde ausgestaltet ist.

27. Vorrichtung gemäß einem der vorherigen Ansprüche,
wobei die Vorrichtung dazu ausgestaltet ist, Zähne und/oder Zahnfleisch mittels Plasma und einem Schallsignal im Ultraschallfrequenzbereich zu reinigen und zu desinfizieren.

28. Lautsprecher aufweisend eine Vorrichtung gemäß einem der vorherigen Ansprüche.

29. Auspuff aufweisend eine Vorrichtung gemäß einem der Ansprüche 1 bis 27.

30. Medizinisches Gerät aufweisend eine Vorrichtung gemäß einem der Ansprüche 1 bis 27.

31. Medizinisches Gerät gemäß dem vorherigen Anspruch,
wobei das medizinische Gerät zur Kariesbehandlung oder zur Wundbehandlung ausgestaltet ist.

32. Medizinisches Gerät gemäß Anspruch 30 oder Anspruch 31,
wobei es sich bei dem medizinischen Gerät um eine Sonde oder ein Endoskop handelt.

33. Gerät zur Schädlingsabwehr aufweisend eine Vorrichtung gemäß einem der Ansprüche 1 bis 27.

34. Analysegerät zur Partikelanalyse aufweisend eine Vorrichtung gemäß einem der Ansprüche 1 bis 27,
wobei die Vorrichtung angeordnet und ausgestaltet ist, Partikel für Analysezwecke und/oder zur Reinigung des Abgasstroms und/oder zum Abbau der betreffenden Partikel zu ionisieren.

35. Rohrsystem aufweisend eine Vorrichtung gemäß einem der Ansprüche 1 bis 27 oder einen Lautsprecher gemäß Anspruch 28 oder einen Auspuff gemäß Anspruch 29 oder ein medizinisches Gerät gemäß Anspruch 30 oder ein Gerät zur Schädlingsabwehr gemäß Anspruch 33 oder ein Analysegerät zur Partikelanalyse gemäß Anspruch 34.

## Claims

1. Device for generating a non-thermal atmospheric pressure plasma, having
a first piezoelectric transformer (1) which is designed to ignite a non-thermal atmospheric pressure plasma in a process medium, and
a control circuit (11), which is designed to apply an input voltage to the first piezoelectric transformer (1), wherein the control circuit (11) is designed to perform a modulation of the input voltage in such a way that the first piezoelectric transformer (1) generates an acoustic signal as a result of the modulation.

2. Device according to the preceding claim,
wherein the modulation is an amplitude modulation.

3. Device according to either of the preceding claims,
wherein the control circuit (11) is designed to apply an alternating voltage with a carrier frequency to the first piezoelectric transformer (1) as the input voltage and to modulate the amplitude of the applied input voltage with a modulation frequency, wherein the modulation frequency is lower than the carrier frequency.

4. Device according to one of the preceding claims,
wherein the acoustic signal has frequencies in an audible frequency range and/or in an ultrasonic frequency range.

5. Device according to one of the preceding claims,
wherein the device has a housing (12) in which the first piezoelectric transformer (1) is arranged.

6. Device according to the preceding claim,
wherein the housing (12) is a resonant volume.

7. Device according to the preceding claim,
wherein the housing (12) has a catalytically active wire mesh.

8. Device according to one of Claims 5 to 7,
wherein the housing (12) is trumpet-shaped.

9. Device according to one of Claims 5 to 8,
wherein the housing (12) is designed to destroy ozone produced during a plasma ignition.

10. Device according to one of the preceding claims,
wherein the piezoelectric transformer (1) is a Rosen transformer.

11. Device according to one of the preceding claims,
wherein the first piezoelectric transformer (1) has an output area (3) on which a high voltage can be generated, which is sufficient to ignite the non-thermal atmospheric pressure plasma without a separate counter-electrode in the process medium.

12. Device according to one of Claims 1 to 10,
wherein the device also has a counter-electrode (13), and wherein the device is designed to ignite the plasma by means of a voltage generated between an output area (3) of the first piezoelectric transformer (1) and the counter-electrode (13).

13. Device according to one of the preceding claims,
for enabling, accelerating or catalysing chemical reactions.

14. Device according to the preceding claim,
for destroying or breaking down pollutants, for example nitrogen oxides, carbon monoxide and/or fine particulates.

15. Device according to one of the preceding claims, which is designed to activate or to sterilize surfaces.

16. Device according to one of the preceding claims,
wherein the process medium is a gaseous medium, a substance existing in gaseous form at a working temperature and a working pressure, a mixture substance existing in gaseous form at the working temperature and the working pressure, an aerosol, the liquid and/or solid particle suspended in a gas, a liquid, or biological tissue.

17. Device according to one of the preceding claims,
wherein the process medium is an exhaust gas.

18. Device according to the preceding claim,
wherein the exhaust gas is an exhaust gas of an internal combustion engine.

19. Device according to one of the preceding claims,
wherein a dielectric barrier (1) is arranged in front of an output-side end face (10) of the first piezoelectric transformer (1) and
wherein the device is designed to capacitively couple a high voltage generated at the output-side end face (10) into an ignition chamber (17) in which the process medium is located, so that a non-thermal atmospheric pressure plasma is ignited in the process medium in the ignition chamber (17).

20. Device according to one of the preceding claims,
which has a second piezoelectric transformer (14) arranged opposite to the first piezoelectric transformer (1), wherein the control circuit (11) is designed to apply an input voltage to the second piezoelectric transformer (14) in such a way that the non-thermal atmospheric pressure plasma is generated by a voltage between the two piezoelectric transformers (1, 14), wherein the two piezoelectric transformers (1, 14) are driven 180° out of phase with each other.

21. Device according to one of the preceding claims,
wherein the device has at least one further piezoelectric transformer (14), arranged in parallel with the first piezoelectric transformer (1) and having a different length than the first piezoelectric transformer (1), wherein the control circuit (11) is designed to perform a modulation of an input voltage applied to the further transformer (14) such that the further piezoelectric transformer (14) generates an acoustic signal as a result of the modulation.

22. Device according to one of the preceding claims,
wherein the device is a hand-held unit.

23. Device according to one of the preceding claims,
wherein an amplitude of the non-thermal atmospheric pressure plasma generated by the first piezoelectric transformer (1) fluctuates in accordance with the modulation of the input voltage.

24. Device according to one of the preceding claims,
wherein a power of the non-thermal atmospheric pressure plasma generated by the first piezoelectric transformer (1) fluctuates with a modulation frequency of the modulation.

25. Device according to the preceding claim,
wherein the fluctuation in the power of the generated non-thermal atmospheric pressure plasma generates the acoustic signal whose frequency matches the modulation frequency.

26. Device according to one of the preceding claims,
wherein the device is designed for use in dentistry.

27. Device according to one of the preceding claims,
wherein the device is designed to clean and to disinfect teeth and/or the gums using plasma and an acoustic signal in the ultrasonic frequency range.

28. Loudspeaker having a device according to one of the preceding claims.

29. Exhaust system having a device according to one of Claims 1 to 27.

30. Medical device having a device according to one of Claims 1 to 27.

31. Medical device according to the preceding claim,
wherein the medical device is designed for treating caries or for treating wounds.

32. Medical device according to Claim 30 or Claim 31,
wherein the medical device is a probe or an endoscope.

33. Unit for repelling vermin, having a device according to one of Claims 1 to 27.

34. Analysis unit for particle analysis having a device according to one of Claims 1 to 27,
wherein the device is arranged and designed for ionizing particles for analysis purposes and/or for cleaning the exhaust gas stream and/or for breaking down the relevant particles.

35. Pipe system having a device according to one of Claims 1 to 27 or a loudspeaker according to Claim 28 or an exhaust system according to Claim 29 or a medical device according to Claim 30 or a unit for repelling vermin according to Claim 33 or an analysis unit for particle analysis according to Claim 34.

## Revendications

1. Dispositif de génération d'un plasma à pression atmosphérique non thermique, ledit dispositif comprenant
un premier transformateur piézoélectrique (1) qui est conçu pour allumer un plasma à pression atmosphérique non thermique dans un milieu de traitement, et
un circuit de commande (11) qui est conçu pour appliquer une tension d'entrée au premier transformateur piézoélectrique (1),
le circuit de commande (11) étant conçu pour moduler la tension d'entrée de telle sorte que le premier transformateur piézoélectrique (1) génère un signal acoustique à la suite de la modulation.

2. Dispositif selon la revendication précédente,
la modulation étant une modulation d'amplitude.

3. Dispositif selon l'une des revendications précédentes,
le circuit de commande (11) étant conçu pour appliquer une tension alternative ayant une fréquence porteuse comme tension d'entrée au premier transformateur piézoélectrique (1) et pour moduler l'amplitude de la tension d'entrée appliquée avec une fréquence de modulation, la fréquence de modulation étant inférieure à la fréquence porteuse.

4. Dispositif selon l'une des revendications précédentes,
le signal acoustique ayant des fréquences dans une gamme de fréquences audibles et/ou dans une gamme de fréquences ultrasonores.

5. Dispositif selon l'une des revendications précédentes,
le dispositif comportant un boîtier (12) dans lequel est disposé le premier transformateur piézoélectrique (1) .

6. Dispositif selon la revendication précédente,
le boîtier (12) étant un volume de résonance.

7. Dispositif selon la revendication précédente,
le boîtier (12) comportant un treillis de fil métallique catalytiquement actif.

8. Dispositif selon l'une des revendications 5 à 7,
le boîtier (12) étant en forme de trompette.

9. Dispositif selon l'une des revendications 5 à 8,
le boîtier (12) étant conçu pour détruire l'ozone généré lors d'un allumage de plasma.

10. Dispositif selon l'une des revendications précédentes,
le transformateur piézoélectrique (1) étant un transformateur de Rosen.

11. Dispositif selon l'une des revendications précédentes,
le premier transformateur piézoélectrique (1) comportant une région de sortie (3) au niveau de laquelle une haute tension peut être générée qui est suffisante pour allumer le plasma à pression atmosphérique non thermique dans le milieu de traitement sans contre-électrode séparée.

12. Dispositif selon l'une des revendications 1 à 10,
le dispositif comprenant en outre une contre-électrode (13), et le dispositif étant conçu pour allumer le plasma au moyen d'une tension générée entre une région de sortie (3) du premier transformateur piézoélectrique (1) et la contre-électrode (13).

13. Dispositif selon l'une des revendications précédentes, destiné à permettre, accélérer ou catalyser des réactions chimiques.

14. Dispositif selon la revendication précédente, destiné à la destruction ou la dégradation de polluants, par exemple des oxydes d'azote, le monoxyde de carbone et/ou des poussières fines.

15. Dispositif selon l'une des revendications précédentes, qui est prévu pour activer ou stériliser des surfaces.

16. Dispositif selon l'une des revendications précédentes, le milieu de traitement étant un milieu gazeux, une substance présente sous forme gazeuse à une température d'utilisation et une pression d'utilisation, des mélanges de substances présents sous forme gazeuse à la température d'utilisation et à la pression d'utilisation, un aérosol, des particules liquide et/ou solides en suspension dans un gaz, un liquide ou un tissu biologique.

17. Dispositif selon l'une des revendications précédentes,
le milieu de traitement étant un gaz d'échappement.

18. Dispositif selon la revendication précédente,
le gaz d'échappement étant un gaz d'échappement d'un moteur à combustion interne.

19. Dispositif selon l'une des revendications précédentes,
une barrière diélectrique (1) étant disposée devant un côté frontal en sortie (10) du premier transformateur piézoélectrique (1) et
le dispositif étant conçu pour injecter par couplage capacitif une haute tension, générée au niveau du côté frontal en sortie (10), dans une chambre d'allumage (17) dans laquelle se trouve le milieu de traitement, de façon à allumer un plasma à pression atmosphérique non thermique dans le milieu de traitement se trouvant dans la chambre d'allumage (17).

20. Dispositif selon l'une des revendications précédentes, qui comporte un deuxième transformateur piézoélectrique (14) qui est disposé en face du premier transformateur piézoélectrique (1), le circuit de commande (11) étant conçu pour appliquer une tension d'entrée sur le deuxième transformateur piézoélectrique (14) de façon à ce que le plasma à pression atmosphérique non thermique soit généré par une tension entre les deux transformateurs piézoélectriques (1, 14), les deux transformateurs piézoélectriques (1, 14) étant excités avec un déphasage de 180° l'un par rapport à l'autre.

21. Dispositif selon l'une des revendications précédentes,
le dispositif comportant au moins un autre transformateur piézoélectrique (14) qui est disposé parallèlement au premier transformateur piézoélectrique (1) et qui a une longueur différente de celle du premier transformateur piézoélectrique (1), le circuit de commande (11) étant conçu pour moduler une tension d'entrée appliquée sur l'autre transformateur (14) de telle sorte que l'autre transformateur piézoélectrique (14) génère un signal acoustique à la suite de la modulation.

22. Dispositif selon l'une des revendications précédentes,
le dispositif étant un appareil portatif.

23. Dispositif selon l'une des revendications précédentes,
une amplitude du plasma à pression atmosphérique non thermique, qui est généré par le premier transformateur piézoélectrique (1), fluctuant en fonction de la modulation de la tension d'entrée.

24. Dispositif selon l'une des revendications précédentes,
la puissance du plasma à pression atmosphérique non thermique généré avec le premier transformateur piézoélectrique (1) fluctuant à la fréquence de modulation de la modulation.

25. Dispositif selon la revendication précédente,
le signal acoustique, dont la fréquence coïncide avec la fréquence de modulation, étant généré par la fluctuation de la puissance du plasma à pression atmosphérique non thermique généré.

26. Dispositif selon l'une des revendications précédentes,
le dispositif étant conçu pour être utilisé en dentisterie.

27. Dispositif selon l'une des revendications précédentes,
le dispositif étant conçu pour nettoyer et désinfecter les dents et/ou les gencives au moyen d'un plasma et d'un signal acoustique dans la gamme des fréquences ultrasonores.

28. Haut-parleur comportant un dispositif selon l'une des revendications précédentes.

29. Échappement comprenant un dispositif selon l'une des revendications 1 à 27.

30. Appareil médical comportant un dispositif selon l'une des revendications 1 à 27.

31. Dispositif médical selon la revendication précédente,
le dispositif médical étant conçu pour le traitement de caries ou pour le traitement de plaies.

32. Appareil médical selon la revendication 30 ou la revendication 31,
l'appareil médical étant une sonde ou un endoscope.

33. Appareil antiparasitaire comportant un dispositif selon l'une des revendications 1 à 27.

34. Appareil d'analyse de particules comportant un dispositif selon l'une des revendications 1 à 27,
le dispositif étant disposé et conçu pour ioniser des particules à des fins d'analyse et/ou pour nettoyer le flux de gaz d'échappement et/ou pour dégrader les particules concernées.

35. Système de canalisation comprenant un dispositif selon l'une des revendications 1 à 27 ou un haut-parleur selon la revendication 28 ou un échappement selon la revendication 29 ou un appareil médical selon la revendication 30 ou un appareil antiparasitaire selon la revendication 33 ou un appareil d'analyse de particules selon la revendication 34.
